# EUROPÄISCHE PATENTSCHRIFT

(11) **EP 0 898 159 B1**
(45) Veröffentlichungstag und Bekanntmachung des Hinweises auf die Patenterteilung: **27.02.2008**
(21) Anmeldenummer: 98114542.8
(22) Anmeldetag: 03.08.1998
(51) Int. Cl.: G01J 5/10

(54) **Sensorsystem und Herstellungsverfahren sowie Selbsttestverfahren**
Sensor system, method for manufacturing and self-test method
Système de capteur, procédé de fabrication et procédé d'autocontrôle

(30) Priorität: 14.08.1997 DE 19735379
(43) Veröffentlichungstag der Anmeldung: 24.02.1999
(73) Patentinhaber: PerkinElmer Optoelectronics GmbH, 65199 Wiesbaden (DE); ROBERT BOSCH GMBH, 70469 Stuttgart (DE); Fraunhofer-Gesellschaft zur Förderung der angewandten Forschung e.V., 80686 München (DE)
(72) Erfinder: Schieferdecker, Jörg, Dr. Ing.habil, 65197 Wiesbaden (DE); Simon, Marion, Dr.,Dipl.-Phys., 35041 Marburg (DE); Storck, Karlheinz, Dipl.-Ing.(FH), 65391 Lorch (DE); Rothley, Manfred, 76703 Kraichtal (DE); Zabler, Erich, 76297 Stutensee (DE); Jähne, Rolf, 01458 Ottendorf-Okrilla (DE)
(74) Vertreter: Beetz & Partner

(56) Entgegenhaltungen:
- EP-A- 0 640 815
- US-A- 3 801 949
- PATENT ABSTRACTS OF JAPAN vol. 95, no. 06, 31. Juli 1995 (1995-07-31) & JP 07 072014 A (MATSUSHITA), 17. März 1995 (1995-03-17)

## Beschreibung

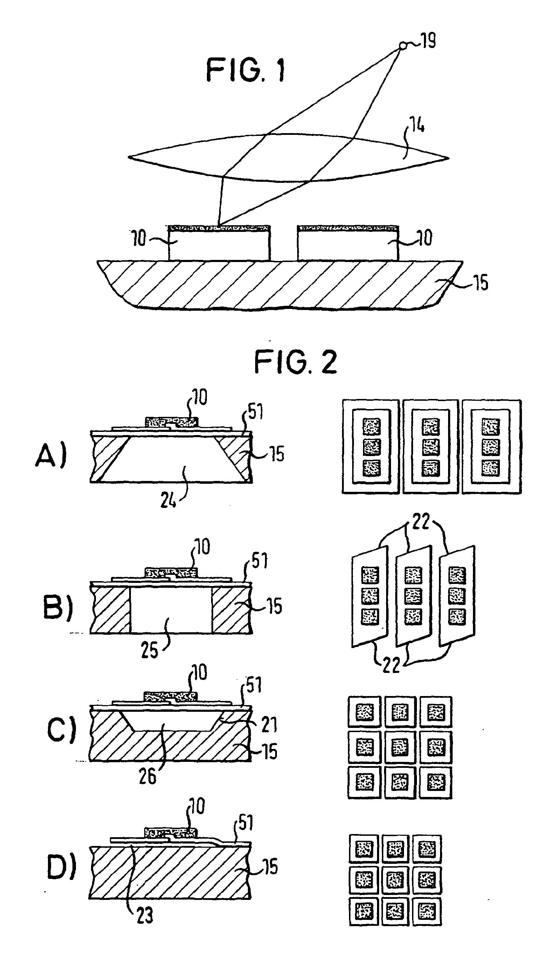

Die Erfindung betrifft ein Herstellungsverfahren für ein Sensorsystem gemäß dem Oberbegriff des Anspruchs 1. Das Sensorsystem dient dem Erfassen von Wärmestrahlung. Zur Erfassung von Wärmestrahlung, insbesondere Infrarotstrahlung (IR-Strahlung), sind verschiedene Anordnungen bekannt. Fig. 1 zeigt schematisch den prinzipiellen Aufbau. Auf einem Substrat 15 sind zwei (oder mehrere) Sensorelemente 10 angebracht. Die von einer Wärmestrahlungsquelle 19 ausgesandte Wärme- bzw. IR-Strahlung wird z.B. durch eine Linse 14 auf die Erfassungsflächen der Sensorelemente 10 abgebildet. Die Strahlung wird durch diese Anordnung auf eines von mehreren Sensorelementen 10 abgebildet, so daß entsprechend der Anzahl von Sensorelementen 10 eine Auflösung nach unterschiedlichen Raumwinkelbereichen möglich ist.

Solche Systeme haben den Nachteil, daß es aufgrund von Wärmeleitung zwischen einzelnen Sensorelementen 10 zu thermischem Über- bzw. Nebensprechen kommen kann. Dies bedeutet, daß ein Sensorelement 10, das nicht von (durch eine Optik abgebildete) Infrarotstrahlung beschienen wird, gleichwohl ein Signal ausgibt, weil es Wärme von benachbarten, von Wärmestrahlung beschienenen Sensorelementen 10 empfängt. Ein Sensorelement kann sich hierbei z.B. um mehrere zehntel Grad erwärmen. Diese Wärme kann sich zu einem nicht beschienenen Nachbarelement ausbreiten und dort ebenfalls zu einem Ausgangssignal führen. Dadurch wird der Kontrast des Sensorsystems schlechter. Außerdem ist es bisher nicht möglich, die Funktionsfähigkeit des Sensorsystems (einschließlich aller einzelner Sensorelemente 10) in einfacher Weise während des Betriebs zu überprüfen.

Aus der US 3 801 949 ist es bekannt, Thermopiles auf einer thermisch schlecht leitfähigen Trägermembran aufzubringen, die über Ätzgruben im Trägersubstrat aufgespannt ist. Die Ätzgruben dienen der thermischen Isolierung des Sensorelements 10 gegen das Substrat 15 und damit der Erhöhung der Empfindlichkeit des Sensorsystems. Auch bei diesem Aufbau wird jedoch Nebensprechen festgestellt, so daß die Wärmeisolierung der einzelnen Sensorelemente gegeneinander nicht ausreicht. Außerdem ist nur ein vergleichsweise kleiner Teil der Substratoberfläche tatsächlich von Sensorelementen 10 überdeckt, weil die von der Substratrückseite her gebildeten Ätzgruben nicht senkrechte Wände aufweisen, die eine große Beabstandung der einzelnen auf der Substratvorderseite angebrachten Sensorelemente erzwingen. Dadurch ist die Erfassungsempfindlichkeit gering, und kleinere Punktquellen können aufgrund der Abbildung durch die Linse auf Stellen zwischen Sensorelementen abgebildet werden, so daß sie nicht erfaßt werden und das Sensorsystem damit unzuverlässig arbeitet.

Fig. 2 zeigt schematisch im Schnitt sowie in der Draufsicht nicht maßstäblich Aufbauten, wie sie im Stand der Technik bekannt sind. In Figur 2A befindet sich das Sensorelement 10 über einer Ätzgrube 24, die schräge Wände hat. Die schrägen Wände ergeben sich aufgrund der Beeinflussung des bekannten Herstellungsverfahrens durch die Kristallorientierung im Substrat 15. Dadurch sind die Sensorelemente 10 weit voneinander beabstandet, so daß die Flächenfüllungsdichte niedrig und die Erfassungszuverlässigkeit nicht befriedigend ist. In Fig. 2B ist eine Ausführungsform gezeigt, bei der die Ätzgruben 25 rautenförmigen Grundriß mit in Dickenrichtung senkrechten Wänden haben. Der rautenförmige Grundriß entsteht bei dieser Ausführungsform ebenfalls aufgrund der Beeinflussung des Ätzverfahrens durch die Kristallorientierung. Figur 2C zeigt eine Ausführungsform, bei der durch ein Ätzverfahren von der Substratvorderseite her Vertiefungen 26 gebildet werden. Auch diese Vertiefungen 26 weisen schräge Wände 21 auf, so daß die Sensorelemente 10 selbst vergleichsweise weit voneinander beabstandet sind. Fig. 2D zeigt schließlich eine Ausführungsform, bei der ein Spalt 23 zwischen Sensorelement 10 und Substrat 15 gebildet wird, indem zunächst eine Opferschicht aufgebracht und diese nach Ausbilden des Sensorelements 10 darauf wieder entfernt wird. Wegen des geringen Abstandes ist dabei die thermische Isolierung des Sensorelements gegen das Substrat 15 schlecht, so daß die Signalamplitude und damit die Empfindlichkeit des Sensorsystems gering ist. Verfahren, die auf der Verwendung von Opferschichten beruhen, sind z.B. in der DE 19 539 696 A1 oder in der EP 0 534 768 oder in PCT/EP89/01082 beschrieben. Verfahren, die das anisotrope Ätzverhalten von Kristallen nutzen, sind in EP 0 640 815 A1 oder PCT/AU91/00162 beschrieben. Bei anisotropen Ätzverfahren ist die erreichbare Packungsdichte durch die Kristallstruktur begrenzt. Mit Opferschicht-Verfahren lassen sich hohe Packungsdichten und ein geringes Übersprechen erreichen. Da aber technologiebedingt die Wannen- bzw. Hohlraumtiefe nur einige µm beträgt, ist insgesamt die thermische Isolation der Sensorelemente 10 und damit die Signalamplitude nicht zufriedenstellend.

Die JP 07072014 beschreibt einen pyroelektrischen Infrarotsensor. Er hat eine Selbstdiagnosefunktion. Mittels einer Kompensationselektrode wird die Temperatur auf einen bestimmten festen Wert erhöht, und der Detektionsausgang der Photodetektoren wird dabei beobachtet.

Die US 3 801 949 beschreibt einen Thermodetektor und ein Herstellungsverfahren hierfür. Über Gesenken in einem Substrat ist eine Isolierschicht angebracht, auf der ein Detektorelement angebracht ist. Die Gesenke sind mittels eines geeigneten Ätzmittels hergestellt.

Die JP 08271344 beschreibt einen monolythischen Thermodetektor. Reaktives Ionenätzen wird als anisotropes Ätzen zur Sensorbildung verwendet.

Die US 5, 583, 058 beschreibt ein Infraroterfassungselement-Array und ein Herstellungsverfahren hierfür. Das Array wird hergestellt, indem von der Vorderseite eines Substrats her durch eine Isolierschicht hindurch eine Opferschicht weggeätzt wird, wobei auf der Oberseite der verbliebenen Isolierschicht Sensorelemente liegen. Es kann aber auch von der Rückseite her durch das Substrat hindurchgeätzt werden.

Aufgabe der Erfindung ist es, ein Herstellungsverfahren für ein Sensorsystem anzugeben das eine qualitativ hochwertige Signalerfassung erlaubt.

Diese Aufgaben wird mit den Merkmalen des Anspruchs 1 gelöst.

Nachfolgend werden bezugnehmend auf die Zeichnungen einzelne Ausführungsformen der Erfindung beschrieben, es zeigen:
- Fig. 1: den prinzipiellen Aufbau eines Sensorsystems,
- Fig. 2A-D: mehrere nach bekannten Verfahren hergestellte Sensorsysteme,
- Fig. 3A, B: Ausführungsformen von Sensor-systemen in Schnitt- und Draufsicht,
- Fig. 4: schematisch den Aufbau eines Thermopile-Sensorelements,
- Fig. 5: in Kombination mehrere weitere Ausführungsformen,
- Fig. 6: das Schaltbild einer weiteren Ausführungsform.

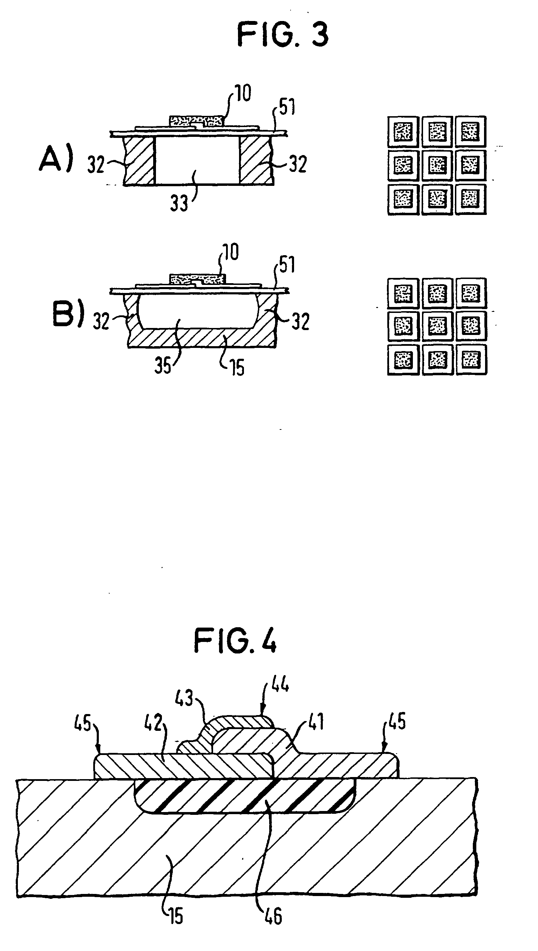

Fig. 3 zeigt Ausführungsformen, bei denen ein Sensorsystem zumindest mehrere Sensorelemente 10 und ein Substrat 15 aufweist. Das Sensorsystem wirkt üblicherweise mit einer Abbildungseinrichtung 14 zusammen. Eine solche Abbildungseinrichtung kann eine Linse, ein Linsensystem, eine geeignete Spiegeleinrichtung oder ähnliches sein, die einfallende Wärmestrahlung auf eines der Sensorelemente 10 abbildet.

Die Sensorelemente 10 sind vorzugsweise thermoelektrische Detektoren, z.B. Thermopile-Sensoren, weil diese gleichlichtempfindlich sind und eine einfache Signalverarbeitung erlauben. Die Sensorelemente 10 können aber auch andere thermische Detektoren sein, beispielsweise pyroelektrische Detektoren, die nur bei Änderungen der einfallenden Wärmestrahlung ein Signal abgeben, oder Bolometer. Auch andere Sensorelemente, die nach Maßgabe einfallender Wärmestrahlung ein Signal abgeben, können verwendet werden.

Bezugnehmend auf Fig. 4 wird der Aufbau eines auf Thermopiles basierenden Sensorelements genauer beschrieben. In Fig. 4 bezeichnet 15 das Substrat, 46 eine Wärmeisolationseinrichtung, 41 und 42 Schichten aus unterschiedlichen, geeigneten Materialien und 43 eine Wärmeabsorptionsschicht. Die gezeigte Anordnung hat ein "warmes Ende" 44 und ein "kaltes Ende" 45. Das warme Ende 44 liegt über der Wärmeisolationseinrichtung 46 und unter der Absorptionsschicht 43. Dadurch wird das warme Ende durch die einfallende Infrarotstrahlung erwärmt. Das kalte Ende 45 hat in der gezeigten Ausführungsform einen "linken" und einen "rechten" Ausläufer, die jeweils über dem als Wärmesenke dienenden Substrat 15 liegen. Durch die beschriebene Anordnung ist sichergestellt, daß sich das warme Ende 44 aufgrund der Infrarotstrahlung unterstützt durch die Absorptionsschicht 43 und die Wärmeisolationseinrichtung 46 erwärmt, während das kalte Ende 45 bzw. dessen zwei Ausläufer im wesentlichen die Temperatur des als Wärmesenke dienenden Substrats 15 beibehalten. Durch den Temperaturunterschied zwischen warmem Ende 44 und kaltem Ende 45 entsteht eine Spannung, die an den beiden Ausläufern des kalten Endes 45 abgegriffen werden kann. Höhe und Polarität der Spannung hängen dabei u.a. von der Wahl der Materialien der Schichten 41 und 42 und der Güte der Isolation zwischen warmem und kaltem Ende ab. Zur Verstärkung des Effekts kann es vorgesehen sein, mehrere in Fig. 4 gezeigte Anordnungen in Serie zu schalten. Es würde dann der Ausläufer des kalten Endes 45 aus dem einen Material mit dem Ausläufer des kalten Endes 45 aus dem anderen Material verbunden werden. Dadurch addieren sich die jeweiligen Signalspannungen, so daß ein stärkerer Effekt erzielt werden kann. Im Sinne dieser Anmeldung bilden gegebenenfalls in Serie geschaltete Aufbauten nach Fig. 4 ein einziges Sensorelement, das eine einzige Signalspannung liefert. Das Sensorelement umfaßt dabei die Gesamtheit der warmen Enden 44 und kalten Enden 45 der gegebenenfalls in Serie geschalteten mehreren Aufbauten nach Fig. 4. Die eigentliche Erfassungsfläche des Sensorelements entspricht dabei im wesentlichen der von der Absorptionsschicht 43 eingenommenen Grundfläche, denn in diesem Bereich erfolgt eine nennenswerte, das Signal hervorrufende Erwärmung. Die Absorptionsschicht 43 ist deshalb vorzugsweise so ausgebildet, daß sie lediglich innerhalb der durch die Wärmeisolationseinrichtung 46 vorgegebenen Grundfläche auf dem Substrat 15 liegt. Die Kontaktstelle der beiden Materialien der Schichten 41 und 42 liegt unter der Absorptionsschicht 43. Da die Fläche der Absorptionsschicht 43 im wesentlichen den die Signalerzeugung herbeiführenden Bereich definiert, kann der von der Absorptionsschicht 43 eingenommene Bereich auch als Sensorbereich 43 des Sensorelements 10 bezeichnet werden. In diesem Zusammenhang wird darauf hingewiesen, daß nicht notwendigerweise eine eigene Schicht 43 vorgesehen sein muß. Es ist auch denkbar, einen zur Absorptionsschicht 43 gleichwirkenden Bereich etwa durch eine geeignete Oberflächenbearbeitung der Schichten 41, 42 im Bereich ihres Kontakts über der Wärmeisolationseinrichtung 46 zu schaffen. Die kalten Enden 45 können, anders als in Fig. 4 dargestellt, auch unmittelbar nebeneinander auf dem Substrat 15 liegen, wobei sich die Schichten 41, 42 dann in etwa parallel hin zur Wärmeisolationseinrichtung 46 und unter die Absorptionsschicht 43 erstrecken.

Die Sensorelemente 10 sind auf einem Substrat bzw. Träger 15 angebracht. Vorzugsweise weist das Substrat 15 Silizium auf. Die Sensorelemente 10 können als Zeile oder als zweidimensionales Feld auf dem Substrat angebracht sein, oder sie können längs einer Bahn oder auf Flächen angebracht sein, die der Abbildung von zu überwachenden Strecken und Arealen durch die Linse 14 entsprechen. Beispielsweise können fünfzehn Sensorelemente 10 in einem 3x5-Feld angeordnet sein. Durch geeignete Kontaktierungen (in den Figuren nicht dargestellt) werden ihre jeweiligen Ausgangssignale so weitergeleitet, daß sie individuell für die einzelnen Sensorelemente 10 abgefragt bzw. ausgewertet werden können. Es sind auch weitaus größere Sensorfelder möglich. Je nach Anforderung können auch beispielsweise 10x10-Felder oder 100x100-Felder ausgebildet werden. Diese haben dann eine entsprechend feinere Ortsauflösung.

Das Substrat 15 weist unter den jeweiligen Sensorelementen 10 Materialaussparungen 33, 35, 54 auf. Unter dem Zwischenraum zwischen benachbarten Sensorelementen 10 kann sich vorzugsweise jeweils ein Materialsteg 32 befinden. Die Materialaussparungen 33, 55, 54 dienen als Wärmeisolationseinrichtung 46 in Fig. 4.

In einer allgemeinen Ausführungsform befindet sich lediglich unter einem oder mehreren Sensorelementen 10 eines Sensorsystems je eine Materialaussparung 33, 35, 54. In einer bevorzugten Ausführungsform ist unter jedem Sensorelement 10 des Sensorsystems eine Materialaussparung 33, 35, 54 vorgesehen.

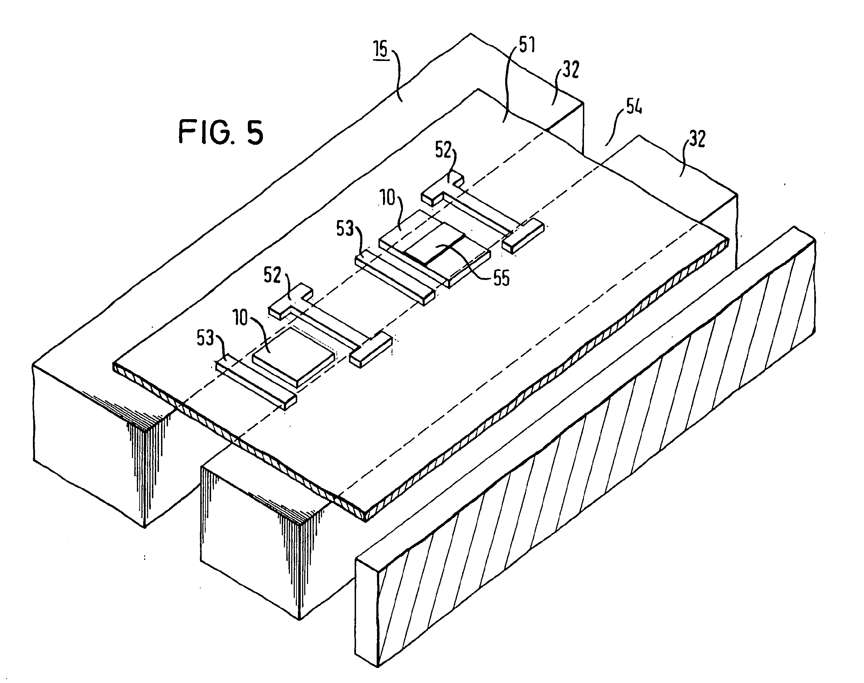

Die Materialaussparungen 33, 35, 54 können - auch innerhalb eines Sensorsystems - verschieden gestaltet sein bzw. durch unterschiedliche Herstellungsverfahren hergestellt werden:
- Mit 33 (Fig. 3A) ist ein Loch bezeichnet, das vorzugsweise von der Substratrückseite her im Substrat 15 gebildet werden kann. Auf der Substratvorderseite sind die Lochränder so dimensioniert, daß das Sensorelement 10 bereichsweise und insbesondere gegebenenfalls mit seinen kalten Enden 45 auf Rändern des Lochs liegt. Fig. 5 zeigt noch eine weitere Ausführungsform, unter der ein Sensorelement 10 am Substrat befestigt werden kann, diese wird später erläutert.
- Fig. 3B zeigt eine Ausführungsform der Materialaussparung, bei der auf der Substratvorderseite her eine Vertiefung 35 im Substrat ausgebildet wird, deren Dimensionierung wiederum so beschaffen sein kann, daß das Sensorelement 10 auf Ränder der Vertiefung 35 aufgesetzt und an ihnen befestigt werden kann. Auch hier kann die Befestigung am Substrat gemäß Fig. 5 erfolgen.

Das erfindungsgemäße Herstellungsverfahren für die Materialaussparungen 33, 35, 54 unter den Sensorelementen 10 umfaßt reaktives Ionenätzen in Bulk-Mikromechanik. Das Verfahren wird auch mit DRIE (= Deep Reaktive Ion Etching) bezeichnet. Hier wird von der Substratrückseite her durch das Substrat hindurch ein Loch gebildet. Es handelt sich um ein Plasmaätzverfahren, mit dem ein Loch mit geraden Wänden und genau dimensionierten Abmessungen hergestellt werden kann. Es können vergleichsweise dünne, lange Löcher gebildet werden. Die einzelnen Löcher benötigen deshalb wenig Platz auf dem Substrat, so daß aufgrund von mehr Sensorelementen pro Substratfläche bzw. mehr Sensorfläche pro Substratfläche die Auflösung sowie die Flächenfüllung und damit die Empfindlichkeit erhöht werden können. In diesem Zusammenhang wird darauf hingewiesen, daß die Fig. 1 bis 5 nicht maßstäblich zu verstehen sind. Sie geben die jeweiligen Ausführungsformen nur qualitativ wieder. Durch reaktives Ionenätzen kann ein Loch 33 gemäß Fig. 3A hergestellt werden. Mit dieser Technik ist es beispielsweise möglich, in einem 500 µm dicken Wafer, der als Substrat 15 dient, Durchlöcher eines beliebigen Durchmessers, insbesondere mit Durchmessern zwischen 50 und 200 µm, regelmäßig beabstandet zu schaffen. Das Loch hat damit die Tiefe entsprechend der Dicke des Wafers, so daß das warme Ende gut isoliert ist und damit die Empfindlichkeit des Sensorelements verbessert ist. Aufgrund der nahezu senkrechten Wände müssen nur dünne Stege 32 stehenbleiben, so daß sich eine hohe Packungsdichte ergibt. Es werden 90 bis 99 % des Lochs mittels reaktiven Ionenätzens erzeugt. Bis zur Endtiefe (100 %) wird dann das Loch mittels eines isotropen Ätzverfahrens erzeugt.

Das obengenannten Verfahren hat den Vorteil, daß es nicht durch die Kristallorientierung im Substrat beeinflußt ist und dadurch keine die Packungsdichte negativ beeinflussenden Randbedingungen vorliegen.

Fig. 5 zeigt in Kombination mehrere weitere Ausführungsformen, mit denen u.a. thermisches Nebensprechen verhindert werden kann. Im Substrat 15 ist hier als Materialaussparung ein länglicher Graben 54 vorgesehen, der durch eines der oben genannten Verfahren von der Substratvorderseite oder der Substratrückseite her gebildet worden sein kann. Mehrere Gräben mit jeweils mehreren Sensorelementen können vorzugsweise parallel zueinander vorgesehen sein. Das Substrat 15 ist von einer Isolationsschicht 51 überzogen. Auf der Isolationsschicht 51 sind die Sensorelemente 10 so angebracht, daß sie zumindest bereichsweise über dem Graben 54 liegen. Insbesondere die Sensorbereiche, die durch die Absorptionsschicht 43 vorgegeben sind, liegen über dem Graben 54. Bezugszeichen 55 zeigt eine Absorptionsschicht entsprechend der Absorptionsschicht 43 in Fig. 4. Unter der Absorptionsschicht 55 liegt das warme Ende des Sensorelements 10, während die kalten Enden über den den Graben 54 einfassenden Stegen 32 liegen. Das vordere Sensorelement 10 liegt vollständig über dem Graben. Diese beiden Optionen sind auch dann möglich, wenn die Materialaussparungen nicht in Form eines Grabens 54 vorgesehen sind, sondern gemäß den in Fig. 3 gezeigten Ausführungsformen.

In der Nähe eines Sensorelements 10 ist eine Isoliereinrichtung 52 vorgesehen. Sie besteht aus einem gut wärmeleitenden Material, beispielsweise einer dünnen Metallschicht. Die Isoliereinrichtung dient als Wärmesenke, die Wärme, die sich über die Isolationsschicht 51 zum benachbarten Sensorelement hin ausbreiten könnte, in andere Richtungen ableitet. Vorzugsweise ist sie so angebracht, daß sie einerseits über Materialaussparungen, beispielsweise Graben 54 oder Loch 33, 35 liegt, und andererseits über einem der Substratstege 22. Vorzugsweise liegt sie zwischen benachbarten Sensorelementen 10. Da Silizium ein vergleichsweise guter Wärmeleiter ist, ist es vorteilhaft, Wärme aus den nicht mit dem Substrat in Verbindung stehenden Bereichen der Isolationsschicht 51 in solche Bereiche der Isolationsschicht 51 zu leiten, die mit dem Substrat unmittelbar in Verbindung stehen, so daß die Wärme dann in das Substrat 15 bzw. dessen Stege 32 diffundieren kann und nicht zum benachbarten Sensorelement gelangt. Die Isoliereinrichtung 52 kann auch durch Substratbrücken gebildet werden, die unter der Isolationsschicht 51 liegen und die den Graben 54 bzw. größere Löcher überspannen. Solche Substratbrücken wirken für die sich über die Isolationsschicht 51 ausbreitende Wärme ebenfalls als Wärmesenke, so daß die Wärme in das Substrat 15, 32 abgeleitet wird. Die Isoliereinrichtung kann auch in Form von die Materialaussparung überquerenden Schlitzen in der Isolationsschicht 51 oder als Kombination von Brücken und Schlitzen ausgebildet sein. Solche Schlitze in der Isolationsschicht 51 unterbrechen den Wärmefluß durch die Isolationsschicht zum benachbarten Sensorelement 10. Die Wärme breitet sich dann in der Isolationsschicht 51 in eine Richtung aus, in der sie in diejenigen Bereiche der Isolationsschicht 51 gelangt, die mit dem Substrat 15 bzw. mit dessen Stegen 32 in Verbindung stehen, so daß die Wärme in diesen Wärmesenken absorbiert wird.

Die Isolationsschicht ist eine Schicht, die Wärme schlechter leitet als Silizium und die elektrisch schlecht leitend ist. Sie dient einerseits der thermischen und elektrischen Isolation und andererseits dem Tragen der Sensorelemente 10 über den Materialaussparungen 23, 25, 44. Sie kann beispielsweise aus Siliziumoxid, Siliziumkarbid und/oder Siliziumnitrid bestehen und ist üblicherweise dünner als 1 µm. Sie kann zuerst ausgebildet werden, und danach werden die Materialaussparungen 33, 35, 54 hergestellt. Hierbei wirkt die Isolationsschicht, wenn von der Substratrückseite her die Materialaussparung gebildet wird, als Ätzstopp. Wenn die Materialaussparung von der Substratvorderseite her gebildet wird, kann die Isolationsschicht 51 beispielsweise durch ein speziell angepaßtes Ätzverfahren durchstoßen werden, beispielsweise durch RIE (reaktives Ionenätzen, "reactive ion etching").

Bezugsziffer 53 bezeichnet Selbsttesteinrichtungen, die für eine Selbsttestfunktion verwendet werden können. Es handelt sich hierbei um Heizelemente, die Sensorelemente 10 mit Wärme beaufschlagen können, so daß überprüft werden kann, ob bei dieser Beaufschlagung die Sensorelemente 10 ein Signal in erwarteter Weise ausgeben. Die Selbsttesteinrichtungen 53 können Heizwiderstände sein, die durch (nicht gezeigte) Zuleitungen Strom empfangen und sich dann, wenn sie von Strom beflossen werden, erwärmen und daraufhin die Sensorelemente 10 durch Wärmestrahlung und/oder durch Wärmeleitung über Substrat 15 und gegebenenfalls vorhandene Isolationsschicht 51 erwärmen. Pro Sensorelement 10 kann eine Selbsttesteinrichtung 53 vorgesehen sein. Die Selbsttesteinrichtungen 53 können aber auch so zwischen Sensorelementen 10 angebracht sein, daß sie zwei oder mehrere der Sensorelemente bestrahlen bzw. erwärmen. Die Selbsttesteinrichtungen 53 können so ausgelegt sein, daß sie individuell angesteuert werden können, oder daß sie gemeinsam angesteuert werden. Die vorzugsweise als Heizwiderstände ausgebildeten Selbsttesteinrichtungen 53 können gerade Bahnen aus einem Widerstandsmaterial sein, die sich vorzugsweise parallel zu einer Kante eines Sensorelements 10 längs der Kante erstrecken. Wenn mehrere Selbsttesteinrichtungen 53 vorgesehen sind, können diese, sofern eine individuelle Ansteuerung nicht notwendig ist, parallel zueinander oder in Serie miteinander verschaltet sein.

In einer bevorzugten Ausführungsform kann das Material für die Selbsttesteinrichtung 53 so gewählt sein, daß die Selbsttesteinrichtung 53 auch die Funktion der Isoliereinrichtung 52 erfüllt. Die beiden Einrichtungen sind dann nicht mehr getrennt, sondern vereint vorgesehen. Das Material ist so zu wählen, daß es sich einerseits bei Stromfluß erwärmt, es andererseits aber eine Wärmeleitfähigkeit hat, die besser ist als diejenige des Fluids (z.B. Luft), das an die Isolationsschicht 51 angrenzt. Vorzugsweise ist die Wärmeleitfähigkeit besser als die der Isolationsschicht 51. Als Materialien sind metallische oder halbleitende Widerstandsschichten, z.B. Poly-Silizium, kristallines Silizium, Aluminium, oder Gold, denkbar. Diese Ausführungsform kann demnach so gestaltet sein, daß über dem Graben 54 abwechselnd je ein Sensorelement 10 sowie eine kombinierte Selbsttest/Isolationseinrichtung 52, 53 liegen. Da eine Selbsttesteinrichtung 53 die zwei am Graben benachbarten Sensorelemente 10 mit Wärme beaufschlagen kann, kann eine Ausführungsform auch so aussehen, daß jede zweite Einrichtung zwischen Sensorelementen 10 eine kombinierte Selbsttest/Wärmeisolationseinrichtung 52, 53 ist, die durch eine geeignete Kontaktierung mit Strom beaufschlagt werden kann, während jede andere (im jeweils anderen Zwischenraum gelegene) Einrichtung eine reine Isolationseinrichtung 52 ist. Dadurch ergibt sich ein kostengünstiger und gleichwohl kompakter Aufbau des Sensorsystems.

Beim Selbsttestverfahren werden die Selbsttesteinrichtungen 53 (Heizwiderstände) erwärmt, so daß diese ihrerseits die Sensorelemente 10 erwärmen bzw. bestrahlen. Daraufhin wird überprüft, ob die jeweiligen Sensorelemente 10 ein qualitativ und/oder quantitativ erwartetes Signal ausgeben. Auf diese Weise kann das Funktionieren einzelner oder aller Sensorelemente 10 überprüft werden. Auch ein Kalibrieren des Sensorsystems ist möglich. Indem die durch den Selbsttest erhaltenen Ausgangssignale mit erwarteten Werten verglichen werden, können Kennwerte eines Sensorelements bzw. des Sensorsystems ermittelt und diese anschließend an Sollwerte angepaßt werden.

Da die Massen der beteiligten Elemente vergleichsweise klein sind, kann der Selbsttest mit vergleichsweise kurzen Zeitkonstanten erfolgen. Dies bietet Vorteile bei bestimmten Anwendungsgebieten, beispielsweise in der Kraftfahrzeugtechnik. Bei modernen Kraftfahrzeugen wird die gesamte Sensorik beim Anlassen des Fahrzeugs überprüft. Dank kurzer Zeitkonstanten kann der Selbsttest in kurzer Zeit, vorzugsweise in weniger als 1 sec, vorgenommen werden, so daß beim Anlassen eines Fahrzeugs ein entsprechender Sensor überprüft werden kann.

Da die Sensorelemente zusätzlich zu den durch das Selbsttestverfahren erzeugten Signalen die sonst auch vorhandene Infrarot-Szenerie "sehen", kann es zur Unterscheidung des Selbsttestsignals von der übrigen Szenerie von Vorteil sein, die Selbsttesteinrichtungen 43 in einem bestimmten zeitlichen Muster anzusteuern. Dieses zeitliche Muster würde sich dann im wesentlichen wieder im Ausgangssignal der geprüften Sensorelemente 10 finden. Das zeitliche Muster kann beispielsweise eine Folge von zwei oder mehreren Impulsen sein oder ein zeitveränderliches Signal. Wegen der aufgrund der niedrigen Massen kurzen Zeitkonstanten sind Signalmuster mit Einzelimpulsen von kürzer als 50 ms, vorzugsweise kürzer als 5 ms, möglich. Sie sind damit schneller als die Veränderungen aufgrund von zu erfassenden Objekten. Sie können dadurch von der parallel zum Selbsttest vorliegenden Infrarot-Szenerie unterschieden werden, so daß auch während des Selbsttests die Überwachung durch Herausrechnen des Testsignals aus dem Summensignal (Selbsttestsignal plus Infrarotszenerie) weitergeführt werden kann. Außerdem kann der Querschnitt bzw. der Widerstand der einzelnen Heizelemente der Selbsttesteinrichtung 53 unterschiedlich sein. Dadurch ergeben sich unterschiedliche Erwärmungsleistungen und damit unterschiedlich starke Erwärmungen bzw. Selbsttestsignale für die den jeweiligen Selbsttesteinrichtungen 53 zugeordneten Sensorelemente. Auch dadurch kann das Selbsttestsignal von der im herkömmlichen Betrieb des Sensorsystems zusätzlich vorhandenen Infrarot-Szenerie unterschieden werden. Mit den obengenannten Verfahren ist es auch möglich, das Selbsttestsignal von Störimpulsen zu unterscheiden.

Das oben beschriebene Ansteuern der Selbsttesteinrichtungen 53 und das anschließende Überprüfen der Ausgangssignale der Sensorelemente 10 erfolgt vorzugsweise durch eine (nicht dargestellte) Steuerung.

Die beschriebenen Sensorelemente 10 geben in der Regel ein Signal aus, das die Intensität der einfallenden Wärmestrahlung quantitativ widerspiegelt, also ein Analogsignal. Aufgrund der Tatsache, daß mehrere Sensorelemente 10 vorgesehen sind, sind damit auch mehrere Analogsignale weiterzugeben bzw. aufzubereiten. Dies kann dadurch geschehen, daß in unmittelbarer Nähe der Sensorelemente 10 die Analogwerte zeitgemultiplext werden und das so entstandene serielle Signal über eine Datenleitung ausgegeben wird. Die Anzahl der benötigten Signalausgabeleitungen reduziert sich durch diese Maßnahme beträchtlich, im Extremfall auf eine einzige.

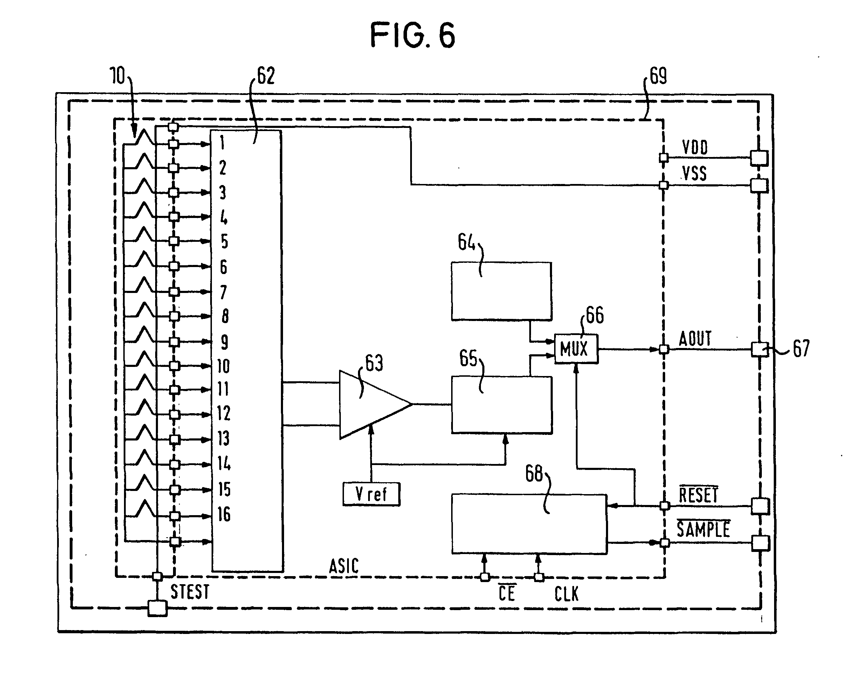

Fig. 6 zeigt beispielhaft ein einschlägiges Schaltbild. Unter 10 sind mehrere Sensorelemente als Schaltbild gezeigt, die jeweils für sich ein Eingangssignal (1 bis 16) in den Analog-Multiplexer 62 eingeben. Das jeweils ausgewählte Signal wird im Verstärker 63 verstärkt. Das vom Verstärker 63 ausgegebene Signal könnte in dieser Weise schon ausgegeben werden. Zusätzlich kann ein Analog-Sample-and-Hold-Glied 65 vorgesehen sein, das das Analogsignal vom Verstärker 63 empfängt. Außerdem kann ein Temperatursensor 64 vorgesehen sein, der ein der absoluten Temperatur des Sensorsystems entsprechendes Analogsignal erzeugt. Durch einen weiteren Multiplexer 66 können die Ausgangssignale von Temperatursensor 64 und Sample-and-Hold-Glied 55 vereint werden, so daß am Datenausgang 67 ein einziges Analogsignal erscheint, das zeitseriell die Ausgangssignale der einzelnen Sensorelemente 10 sowie des gegebenenfalls vorhandenen Temperatursensors 64 zeigt. Eine solche Ausführungsform hat lediglich einen einzigen Datenausgang 67. Daneben werden noch einige weitere wenige Anschlüsse, vorzugsweise 1 bis 2 für Steuerungsfunktionen, sowie die für die Versorgungsspannung benötigt. Bezugsziffer 69 bezeichnet dabei die symbolisch dargestellte Begrenzung des Sensorsystems. Alle dargestellten Komponenten sind räumlich in einem wenige Millimeter umfassenden Bereich angebracht. Das Gesamtsystem läßt sich z.B. auf weniger als 100 mm² aufbauen. Fig. 6 zeigt eine Ausführungsform, bei der keine Analog-Digital-Wandlung erfolgt. Es kann aber auch ein Analog-Digital-Wandler am Ausgang des Verstärkers 63, des Sample-and-Hold-Glieds 65 oder des Multiplexers 66 vorgesehen sein. Bezugsziffer 68 bezeichnet eine Steuerung, vorzugsweise einen Steuerungsprozessor, der die internen Abläufe im Sensorsystem steuert und überwacht.

Fig. 6 zeigt demnach beispielhaft einen Aufbau, bei dem die von den Sensorelementen 10 ausgegebenen Signale eine Signalaufbereitung 62 bis 69 durchlaufen. Die Signalaufbereitung 62 bis 69 gibt - vorzugsweise serielle - analoge oder digitale Daten aus. Der Aufbau gemäß Fig. 6 kann dabei hybrid oder monolithisch sein. Beim monolithischen Aufbau befindet sich die Signalaufbereitung auf dem gleichen Substrat 15 wie die Sensorelemente 10. Beim hybriden Aufbau ist die Signalaufbereitung 62 bis 69 auf einem eigenen Substrat bzw. Chip aufgebaut und mit den Sensorelementen 10 auf dem Substrat 15 elektrisch verbunden. Auch bei diesem Aufbau befinden sich die zwei Substrate jedoch in unmittelbarer räumlicher Nähe und insbesondere innerhalb eines einzigen Gehäuses (symbolisiert durch Bezugsziffer 69), das das Sensorsystem umgibt.

Wie schon weiter oben erwähnt, kann ein Temperatursensor 64 für die absolute Temperatur des Substrats vorgesehen sein. Mit seiner Hilfe wird es möglich, die bezüglich der Subtrattemperatur relativen Ausgangssignale der Sensorelemente 10 auf die absolute Temperatur zu beziehen, so daß eine qualitative Verfeinerung der Ausgangssignale des Sensorsystems erfolgt. Mit einem solchen System wird es beispielsweise möglich, Personen zu erfassen und sie von anderen Wärmestrahlungsquellen zu unterscheiden, sofern diese eine andere Temperatur als ca. 37 °C aufweisen. Außerdem kann die Temperatur von Objekten mit hoher Genauigkeit bestimmt werden, auch wenn die Eigen-Temperatur des Sensors selbst nicht konstant ist.

Die oben erwähnte Signalaufbereitung 62 bis 69 kann außerdem eine Kalibriereinrichtung, beispielsweise in Form sogenannter "fusable links", aufweisen, um die Kennlinie des Sensorsystems bzw. seiner Sensorelemente einzustellen. Es können beispielsweise durch Durchbrennen einzelner Diodenstrecken, die mit Kalibrierwiderständen in Verbindung stehen, Nullpunkte und Verstärkungen herstellerseitig dauerhaft eingestellt werden, so daß ein beliebiges Sensorsystem mit einem anderen hinsichtlich seiner Kennlinie kompatibel ist. So ist es möglich, das Sensorsystem bereits beim Hersteller zu kalibrieren, so daß es beim Anwender austauschbar ist ohne Neukalibrierung. Dies erleichtert den Service wesentlich.

Typische Werte für das Sensorsystem sind: Die Sensorelemente sind üblicherweise rechteckig und haben Kantenlängen zwischen 40 und 500 µm. Vorzugsweise sind sie quadratisch. Der Mittenabstand einzelner Sensorelemente zueinander liegt zwischen 50 µm und 1000 µm. Ein als Substrat verwendeter Wafer kann eine Dicke zwischen 200 und 1000 µm, vorzugsweise zwischen 300 und 500 µm haben. Die Vertiefungen 35 haben vorzugsweise eine Tiefe von über 100 µm.

Ein derartig kleines Sensorsystem kann für verschiedene Zwecke eingesetzt werden. Ein Anwendungsbereich ist die Überwachung von Fahrzeuginnenräumen. Das Sensorsystem kann am Dach des Fahrzeugs angebracht sein und von seiner Auflösung (entsprechend der Anzahl der Sensorelemente 10) so gestaltet sein, daß erkannt werden kann, ob einzelne Sitze im Fahrzeug besetzt sind. Nach Maßgabe des so gewonnenen Signals können andere Fahrzeugfunktionen gesteuert werden, beispielsweise Klimaanlage, Airbag, usw.. Sensorsysteme wie oben beschrieben können auch für die Gebäudeüberwachung oder allgemein für die Personendetektion verwendet werden.

Das beschriebene Sensorsystem kann mit oder ohne Abbildungsoptik und der Signalverarbeitung in einem kleinen Transistorgehäuse von 1 cm³ oder weniger Rauminhalt aufgebaut sein.

## Patentansprüche

1. Verfahren zur Herstellung eines Silizium aufweisenden Substrats für ein Sensorsystem zur Erfassung von Wärmestrahlung, das auf der einen Substratoberfläche mehrere Sensorelemente auf einer Membran aufweist, wobei unter der Membran eine Materialaussparung mittels reaktiven Ionenätzens gebildet wird,
**dadurch gekennzeichnet, daß**
die Materialaussparung als Loch mit geraden Wänden ausgehend von der anderen Oberrfläche des Substrats auf die Membran zu bis zu einer Tiefe von 90 % bis 99 % der Gesamttiefe durch DRIE (deep reactive ion etching) gebildet und bis zur Endtiefe durch isotropes Ätzen erzeugt wird.

## Claims

1. Process for the production of a silicon-containing substrate for a sensor system for detecting thermal radiation, which comprises, on the one substrate surface, a plurality of sensor elements on a membrane, beneath the membrane a depression in the material being formed by reactive ion etching,
**characterized in that**
the depression in the material is formed as a hole having straight walls extending from the other surface of the substrate towards the membrane up to a depth from 90 % to 99% of the total depth by DRIE (deep reactive iron etching) and, up to the final depth, it is generated by isotropic etching.

## Revendications

1. Procédé pour la fabrication d'un substrat contenant du silicium destiné à un système de capteur pour l'enregistrement du rayonnement thermique, doté sur l'une des surfaces du substrat de plusieurs éléments capteurs sur une membrane, un évidemment de matériau étant formé sous la membrane à l'aide d'une gravure ionique réactive,
**caractérisé en ce que**
l'évidement est pratiqué sous forme de trou ayant des parois droites à partir de l'autre surface du substrat sur la membrane, jusqu'à une profondeur de 90 % à 99 % de la profondeur totale par le procédé DRIE (gravure ionique réactive profonde), et que la profondeur finale est obtenue par un procédé de gravure isotrope.
